# EUROPEAN PATENT APPLICATION

(11) **EP 2 416 634 A1**
(43) Date of publication of application: **08.02.2012**
(21) Application number: 10171612.4
(22) Date of filing: 02.08.2010
(51) Int. Cl.: H05K 3/34, H01L 21/60

(54) **Method to form solder deposits on substrates**

(71) Applicant: ATOTECH Deutschland GmbH, 10553 Berlin (DE)
(72) Inventor: Matejat, Kai-Jens, 14109, Berlin (DE); Lamprecht, Sven, 16727, Oberkrämer/Eichstädt (DE); Ewert, Ingo, 14167, Berlin (DE)
(74) Representative: Wonnemann, Jörg

(57) **Abstract**

Described is a method of forming a solder deposit on a substrate comprising the following steps i) provide a substrate (102) including a permanent resin layer (103) on top of at least one contact area (101) and a temporary resin layer (104) on top of the permanent resin layer (103), ii) contact the entire substrate area including the at least one contact area (101) with a solution suitable to provide a conductive layer (106) on the substrate surface, iii) electroplate a solder deposit layer (107) containing tin or a tin alloy onto the conductive layer (106) and iv) etch away an amount of the solder deposit layer (107) containing tin or a tin alloy sufficient to remove the solder deposit layer (107) from the temporary resin layer (104) area leaving a solder material layer (107) on the at least one contact area (101).

## Description

### Field of the Disclosure

The invention relates to the formation of solder deposits by electroplating, particularly to flip chip packages, more particularly to flip chip joints and board to board solder joints formed by electroplated solder of tin and tin alloys.

### Background of the Invention

Since the introduction of the flip chip technology by IBM in the early 1960s, the flip chip devices have been mounted on an expensive ceramic substrate where the thermal expansion mismatch between the silicon chip and the ceramic substrate is less critical. In comparison with wire bonding technology, the flip chip technology is better able to offer higher packaging density (lower device profile) and higher electrical performance (shorter possible leads and lower inductance). On this basis, the flip chip technology has been industrially practiced for the past 40 years using high-temperature solder (controlled-collapse chip connection, C4) on ceramic substrates. However, in recent years, driven by the demand of high-density, high-speed and low-cost semiconductor devices for the trend of miniaturization of modern electronic products, the flip chip devices mounted on a low-cost organic circuit board (e.g. printed circuit board or substrate) with an epoxy underfill to mitigate the thermal stress induced by the thermal expansion mismatch between the silicon chip and organic board structure have experienced an obviously explosive growth. This notable advent of low-temperature flip chip joints and organic-based circuit board has enabled the current industry to obtain inexpensive solutions for fabrication of flip chip devices.

In the current low-cost flip chip technology, the top surface of the semiconductor integrated circuit (IC) chip has an array of electrical contact pads. The organic circuit board has also a corresponding grid of contacts. The low-temperature solder bumps or other conductive adhesive material are placed and properly aligned in between the chip and circuit board. The chip is flipped upside down and mounted on the circuit board, in which the solder bumps or conductive adhesive material provide electrical input/output (I/O) and mechanical interconnects between the chip and circuit board. For solder bump joints, an organic underfill encapsulant may be further dispensed into the gap between the chip and circuit board to constrain the thermal mismatch and lower the stress on the solder joints.

In general, for achieving a flip chip assembly by solder joints, the metal bumps, such as solder bumps, gold bumps or copper bumps, are commonly pre-formed on the pad electrode surface of the chip, in which the bumps can be any shape, such as stud bumps, ball bumps, columnar bumps, or others. The corresponding solder bumps (or say presolder bumps), typically using a low-temperature solder, are also formed on the contact areas of the circuit board. At a reflow temperature, the chip is bonded to the circuit board by means of the solder joints. After dispensing of an underfill encapsulant, the flip chip device is thus constructed. Such methods are well known in the art and typical examples of the flip chip devices using solder joints are for example described in U.S. Pat. No 7,098,126 (H.-K. Hsieh et al.).

Currently, the most common method for formation of presolder bumps on the circuit board is the stencil printing method. Some prior proposals in relation to the stencil printing method can be referred to U.S. Pat. No. 5,203,075 (C. G. Angulas et al.), U.S. Pat. No. 5,492,266 (K. G. Hoebener et al.) and U.S. Pat. No. 5,828,128 (Y. Higashiguchi et al.). Solder bumping technique for flip chip assemblies requires design considerations regarding both bump pitch and size miniaturization. According to practical experiences, the stencil printing will become infeasible once the bump pitch is decreased below 0.15 millimeter. In contrast, the solder bumps deposited by electroplating offer the ability to further reduce bump pitch down to below 0.15 millimeter. The prior proposals in relation to electroplate bumps on the circuit board for flip chip bonding can be found in U.S. Pat. No. 5,391,514 (T. P. Gall et al.) and U.S. Pat. No. 5,480,835 (K. G. Hoebener et al.). Although eletroplate solder bumping on the circuit board offers finer bump pitch over stencil printing, it presents several challenges for initial implementation.

A multi-step process to form solder on an organic substrate is described in U.S. Pat. No. 7,098,126 (H.-K. Hsieh et al.). In the method, there is initially provided an organic circuit board including a surface bearing electrical circuitry that includes at least one contact area. A solder mask layer that is placed on the board surface and patterned to expose the pad. Subsequently, a metal seed layer is deposited by physical vapor deposition, chemical vapor deposition, electroless plating with the use of catalytic copper, or electroplating with the use of catalytic copper, over the board surface. A resist layer is formed over the metal seed layer and then patterned. A solder material is then formed in the opening by electroplating. Finally, the resist and the metal seed layer beneath the resist are removed. To apply this method various patterning steps are required which is not desired from the overall standpoint of process efficiency. Each patterning step is a potential cause of mismatched patterns. Furthermore the method has its limitations if the distance between adjacent contact areas (pitch) is very small as a result of the miniaturization of electronic devices.

A fabrication method of conductive bump structures of circuit boards is disclosed in US 2006/0219567 A1. A solder material is electroplated onto the substrate which is partially protected by a patterned solder mask. Next, an etch resist is deposited onto the layer of solder material. The etch resist is then patterned in a way that the solder material coated connecting pads are protected during the following etching step. Solder material which is not needed for the solder depots is then etched away leaving only the etch resist protected solder depot above the connecting pads. Next, the etch resist is removed.

The European patent application EP 2 180 770 A1 discloses a method for formation of solder deposit layers wherein a solder resin layer is deposited onto a substrate having contact areas. Said solder resin layer is patterned in order to expose said contact areas. Next, an additional resin layer is deposited onto the patterned solder resin layer and again patterned. This method can lead to a misalignement of the individually patterned solder resin layer and additional resin layer in case of small contact area size and narrow pitch distance.

### Summary of the Disclosure

It is therefore an objective of the present invention to adopt an electroplating method of tin and tin alloys to produce a uniform layer of a solder deposit on a substrate. Such baths should be suitable to fill recess structures possessing high aspect ratios without leaving voids or dimples.

Another object of the present invention is to provide a method for solder deposition having a reduced number of plating steps and which is universally applicable even when the solder resist openings have different dimensions.

Another object of the present invention is to provide a method for solder deposit formation which avoids pattern misalignment.

In summary, a method of fabricating electroplate solder deposits on a substrate for forming flip chip joints and board to board solder joints is disclosed. According to the present invention, there is provided a non-conductive substrate like a circuit board including at least one contact area.

A substrate having contact areas which are covered by a permanent resin layer are coated with a temporary resin layer. Contact area openings are generated in the substrate by methods such as layer drilling, plasma etching, spark erosion and mechanical drilling in order to expose the at least one contact area.

Next, a solder material layer containing a tin or tin alloy is then plated on the conductive areas of the substrate to form a solder deposit. Thereafter, excess solder material is etched away in an amount sufficient to remove the solder material from areas not covering the at least one contact area leaving a solder deposit on the at least one contact area to form a solder depot. Also removed, preferably in the same process step, is the conductive seed layer from the area not covering the at least one contact area.

No masking step such as application of organic resists or metal resists is applied when removing the excess solder material and conductive seed layer not covering the at least one contact area.

### Brief Description of the Drawings

Fig. 1 shows the two-step formation of contact area openings with misalignment according to processes known in the art.
Fig. 2 shows a method according to the present invention to obtain a solder deposit layer on a substrate.
Fig. 3 shows a method according to the present invention to obtain a solder resin layer defined pad with a solder deposit layer.
   - **101**: contact area
   - **102**: non-conductive substrate
   - **103**: permanent resin layer
   - **104**: temporary resin layer
   - **105**: contact area opening
   - **106**: conductive seed layer
   - **107**: solder deposit layer
   - **108**: reflowed solder deposit layer
   - **109**: solder resin layer
   - **110**: solder resin opening
   - **111**: temporary resin opening

### Detailed Description of the Invention

The invention provides a method of forming a solder deposit on a substrate by electroplating a tin or tin alloy layer. The process is particularly suitable for fabricating solder bumps on a circuit board, which is able to form solder bumps with good plating uniformity. The method is in more detail described below. The figures shown herein are simply illustrative of the process. The figures are not drawn to scale, i.e. they do not reflect the actual dimensions or features of the various layers in the chip package structure. Like numbers refer to like elements throughout the description.

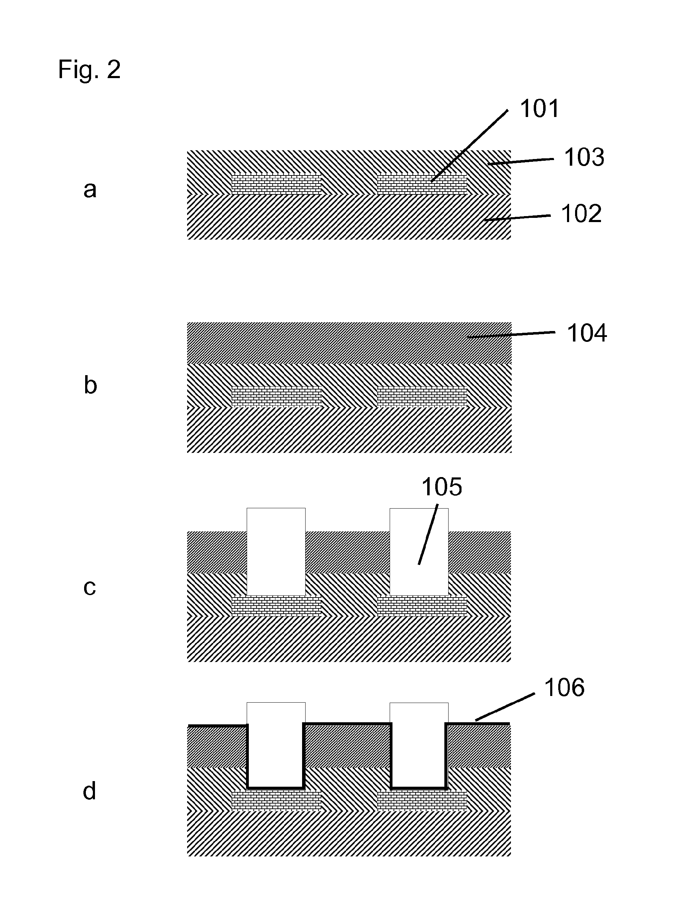

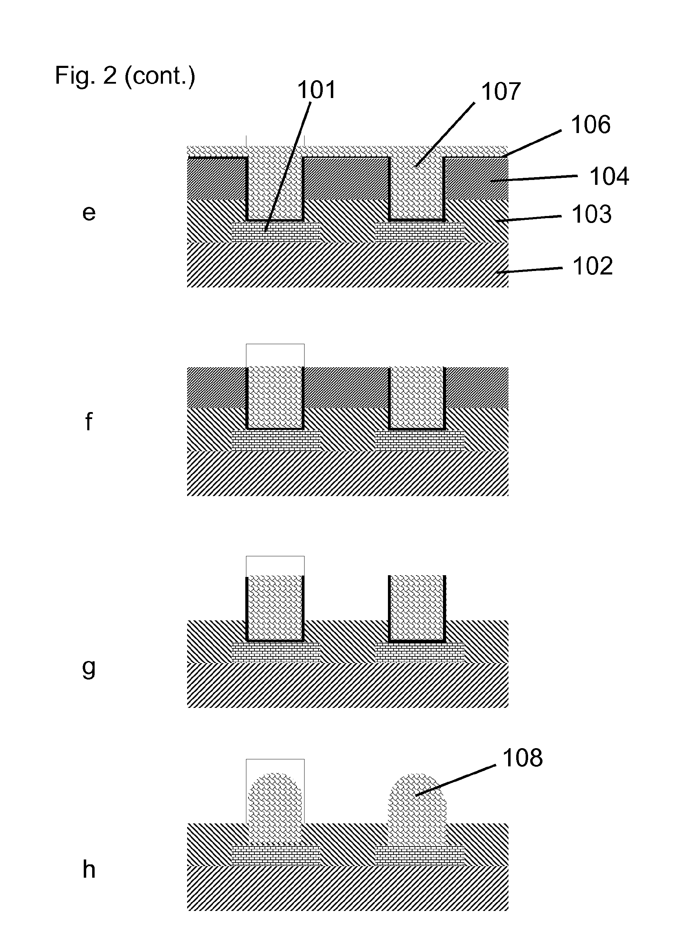

Now referring to Fig. 2a, in accordance with a preferred embodiment of the present invention, there is provided a non-conductive substrate **102**, which has embedded contact pads as a contact area **101** embodiment. The non-conductive substrate **102** can be a circuit board which may be made of an organic material or a fiber-reinforced organic material or a particle-reinforced organic material, for example, epoxy resin, polyimide, bismeleimide triazine, cyanate ester, polybenzocyclobutene, or glass fiber composite thereof and the like. The non-conductive substrate **102** may also be part of a wafer or redistributed wafer. In such a case, a non-conductive surface, e.g., a dielectric material is attached onto the contact areas leading to a structure as shown in Fig. 2 a.

The contact area **101** is typically formed from a metal material, such as copper. Optionally, a barrier layer is formed on the contact area **101** and can e.g. be an adhesive layer of nickel, nickel alloys or a protective layer of gold. Said barrier layer may also be made of nickel, tin, chromium, titanium, silver, gold, palladium, alloys thereof and multi layers thereof which can be made by electoplating, electroless plating, or physical vapor deposition, etc.

The at least one contact area **101** is covered by at least one permanent resin layer **103** which is preferably made of organic material or a fiber-reinforced organic material or a particle-reinforced organic material, etc., for example, epoxy resin, polyimide, bismeleimide triazine, cyanate ester, polybenzocyclobutene, or glass fiber composite thereof, etc.

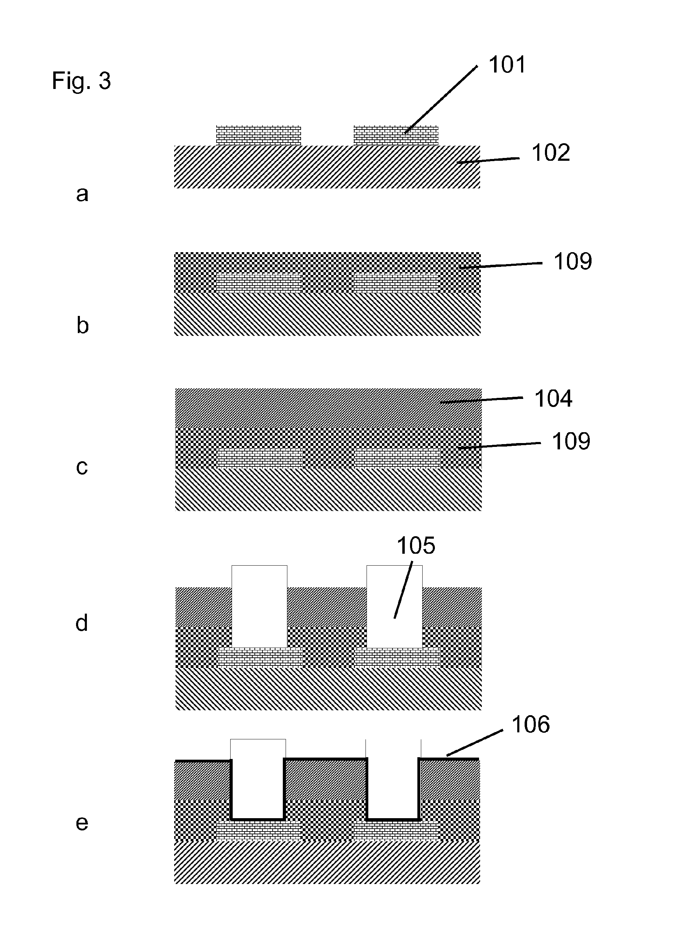

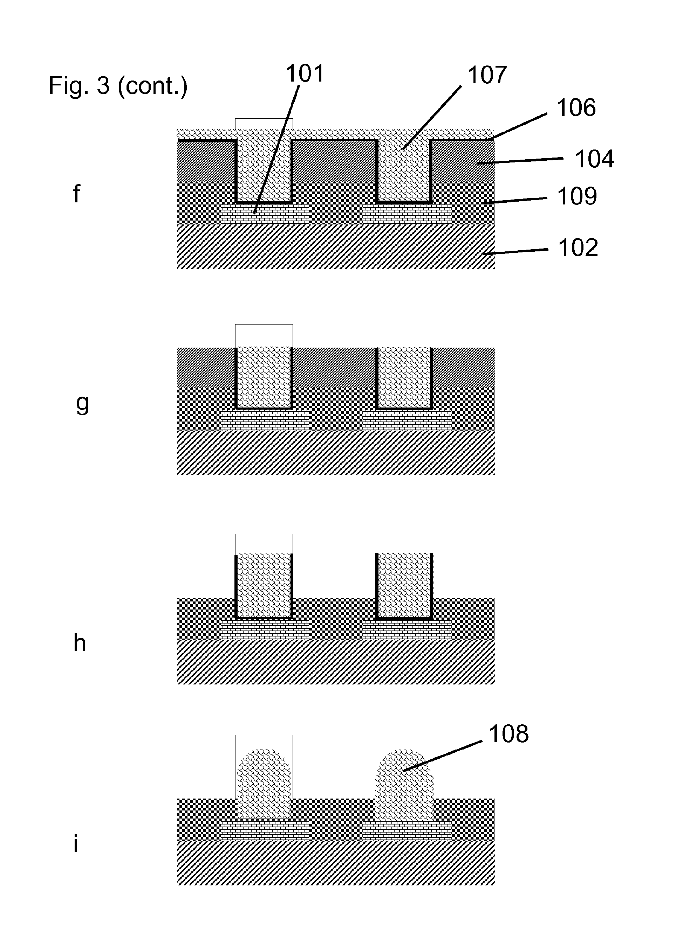

In one embodiment of the present invention the permanent resin layer **103** is a solder resin layer **109** (Fig. 3 b).

Next, at least one temporary resin layer **104** is deposited onto the at least one permanent resin layer **103** (Fig. 2 b). The at least one temporary resin layer **104** is selected from materials such as dry film resists, liquid resists and printable resins.

In still another embodiment of the present invention the permanent resin layer **103** and the temporary resin layer **104** are attached in a single step. Therefore, the permanent resin layer **103** which can be a solder resin layer **109** in one embodiment and the temporary resin layer **104** are applied as a sandwich layer having two different functionalities combined in a sandwich layer consisting of a permanent resin layer **103** and a temporary resin layer **104**: the part of the sandwich layer **103/104** facing the non-conductive substrate **102** and the at least one contact area **101** has the properties and composition of a permanent resin layer **103** and the part of the sandwich layer **103/104** on the opposite side has the properties and composition of a temporary resin layer **104**. The sandwich layer **103/104** which is attached to the substrate can be combined prior to deposition onto the non-conductive substrate **102** and the at least one contact area **101**.

At least one contact area opening **105** is formed in the next step (Fig. 2 c). The contact area opening **105** exposes a contact pad **101**. Methods suitable to form said contact area opening **105** are for example laser drilling, plasma etching, spark erosion and mechanical drilling. Material from both the permanent resin layer **103** and the temporary resin layer **104** are removed in a single step in order to form a contact area opening **105**.

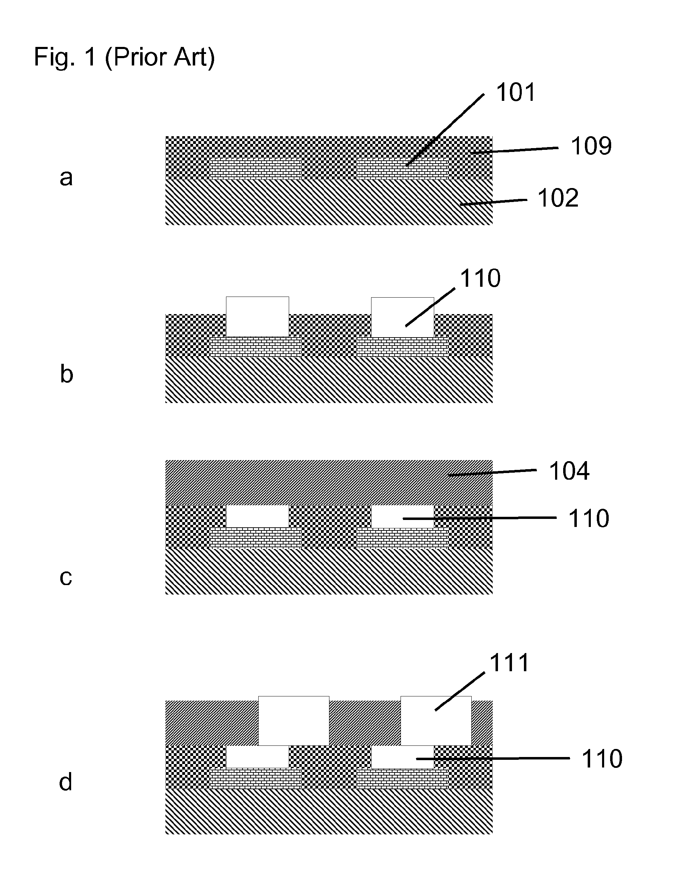

The main advantage of said "multi layer drilling" method is that no misalignment of the openings in the permanent resin layer **103** and the temporary resin layer **104** can occur. Such misalignment of openings is a severe problem, especially for opening diameters of ≤ 150 µm, when applying methods known on the art. In known methods the contact pad openings are formed in two separate steps (Fig. 1). A first solder resist opening **110** is formed in the permanent resin layer **103** which can be a solder resist layer **109**, by methods such as photo structuring, drilling or screen printing (Fig. 1 b). Next, a temporary resin layer **104** is attached (Fig. 1 c) and temporary resin openings **111** are formed in a second photo structuring method, by drilling or screen printing (Fig. 1 d). A contact area opening **105** consists then of a solder resin opening **110** and a temporary resin layer opening **111** which are misaligned.

In order to fabricate a solder deposit containing a tin or tin alloy by electroplating on a non-conductive surface **102**, a conductive seed layer formed on the non-conductive surface is required to initiate the electroplating. Such a conductive seed layer **106** is depicted in Fig. 2 d. The seed layer is for example formed by electroless deposition in the conventional manufacturing industry of non-conductive surfaces and is well known in the art.

According to the present invention the conductive seed layer **106** is deposited over the entire surface of the non-conductive substrate **102** including the at least one contact area **101**, the permanent resin layer **103** and the temporary resin layer **104**.

The non-conductive substrates can be activated by various methods which are described, for example, in Printed Circuits Handbook, C. F. Coombs Jr. (Ed.), 6th Edition, McGraw Hill, pages 28.5 to 28.9 and 30.1 to 30.11. These processes involve the formation of a conductive layer comprising carbon particles, Pd colloids or conductive polymers.

Some of these processes are described in the patent literature and examples are given below:
European patent EP 0 616 053 describes a process for applying a metal coating to a non-conductive substrate (without an electroless coating) comprising:
   a. contacting said substrate with an activator comprising a noble metal/Group IVA metal sol to obtain a treated substrate;
   b. contacting said treated substrate with a self accelerating and replenishing immersion metal composition having a pH above 11 to pH 13 comprising a solution of;
      (i) a Cu(II), Ag, Au or Ni soluble metal salt or mixtures thereof,
      (ii) a Group IA metal hydroxide,
      (iii) a complexing agent comprising an organic material having a cumulative formation constant log K of from 0.73 to 21.95 for an ion of the metal of said metal salt.

This process results in a thin conductive layer which can be used for subsequent electrocoating. This process is known in the art as the "Connect" process.

United States patent 5,503,877 describes the metallisation of non-conductive substrates involving the use of complex compounds for the generation of metal seeds on a non-metallic substrate. These metal seeds provide for sufficient conductivity for subsequent electroplating. This process is known in the art as the so-called "Neoganth" process.

United States patent 5,693,209 relates to a process for metallisation of a non-conductive substrate involving the use of conductive pyrrole polymers. The process is known in the art as the "Compact CP" process.

European patent 1 390 568 B1 also relates to direct electrolytic metallisation of non-conductive substrates. It involves the use of conductive polymers to obtain a conductive layer for subsequent electrocoating. The conductive polymers have thiophene units. The process is known in the art as the "Seleo CP" process.

Finally, the non-conductive substrate can also be activated with a colloidal or an ionogenic palladium ion containing solution, methods for which are described, for example, in Printed Circuits Handbook, C. F. Coombs Jr. (Ed.), 6th Edition, McGraw Hill, pages 28.9 and 30.2 to 30.3.

Subsequent electroless plating of a thin intermediate metal coating can optionally been carried out in order to enhance the conductive seed layer **106**. With assistance of the seed layer, electroplating of the solder deposit according to the present invention can then be carried out.

According to the present invention, said conductive seed layer **106** may be made of a single metal layer, a single metal alloy layer or made of multilayer of at least two distinct single layers. Metals and metal alloys suitable as conductive seed layer are selected from the group consisting of copper, tin, cobalt, nickel, silver, tin-lead alloy, copper-nickel alloy, copper-chromium alloy, copper-ruthenium alloy, copper-rhodium alloy, copper-silver alloy, copper-iridium alloy, copper-palladium alloy, copper-platinum alloy, copper-gold alloy and copperrare earth alloy, copper-nickel-silver alloy, copper-nickel-rare earth metal alloy. Copper and copper alloys selected from the group consisting of copper-nickel alloys, copper-ruthenium alloys and copper-rhodium alloys are most preferred as a conductive seed layer **106**.

In accordance with a preferred embodiment of the present invention, said seed layer **106** can also be formed by an electroless plating method, wherein the catalytic metal does not use noble metal but uses copper as the catalytic metal. The typical examples for forming such a catalytic copper on a non-conductive surface can be found in the U.S. Pat. Nos. 3,993,491 and 3,993,848.

The thickness of said conductive seed layer **106** preferably is less than 0.1 millimeter and more preferably between 0.0001 millimeter and 0.005 millimeter. Depending on the solubility of said conductive seed layer **106** in the solder material, said seed layer **106** can either completely dissolve into the solder deposit or still at least partially exist after the reflow process.

A thinner conductive seed layer **106** is preferred, since the thinner seed layer can be removed sooner in the etching solution, the time required for said non-conductive substrate **102** immersed in an etching solution could be shortened. In such a case, the damages to said temporary resin layer **104** by said etching solution will be lowered down to an acceptable low level.

Referring now to Fig. 2e a solder deposit layer **107** containing tin or a tin alloy is then formed on the conductive seed layer **106**.

In accordance with a preferred embodiment of the present invention, said solder deposit layer **107** is tin or a tin alloy made by the mixture of tin and the elements selected from the group consisting of lead, silver, copper, bismuth, antimony, zinc, nickel, aluminium, magnesium, indium, tellurium, and gallium.

Tin and tin alloy plating baths are known in the art. Commonly used tin or tin alloy plating bath compositions and process parameters for plating are described in the following.

Among other components of the bath may be added a source of Sn²⁺ ions, an anti-oxidant, and a surfactant.

The source of Sn²⁺ ions may be a soluble tin-containing anode, or, where an insoluble anode is used, a soluble Sn²⁺ ion source. Tin methane sulfonic acid, Sn(MSA)₂, is a preferred source of Sn²⁺ ions because of its high solubility. Typically, the concentration of the source of Sn²⁺ ions is sufficient to provide between about 10 g/L and about 100 g/L of Sn²⁺ ions into the bath, preferably between about 15 g/L and about 95 g/L, more preferably between about 40 g/L and about 60 g/L. For example, Sn(MSA)₂ may be added to provide between about 30 g/L and about 60 g/L Sn²⁺ ions to the plating bath.

A preferred alloy is tin silver alloy. In such case the plating bath additionally contains a soluble silver salt, commonly used are nitrate, acetate, and preferably methane sulfonate. Typically, the concentration of the source of Ag⁺ ions is sufficient to provide between about 0.1 g/L and about 1.5 g/L of Ag⁺ ions into the bath, preferably between about 0.3 g/L and about 0.7 g/L, more preferably between about 0.4 g/L and about 0.6 g/L. For example, Ag(MSA) may be added to provide between about 0.2 g/L and about 1.0 g/L Ag⁺ ions to the plating bath.

Anti-oxidants may be added to the baths of the present invention to stabilize the bath against oxidation of Sn²⁺ ions in solution. Preferred anti-oxidants such as hydroquinone, catechol, and any of the hydroxyl, dihydroxyl, or trihydroxyl benzoic acids may be added in a concentration between about 0.1 g/L and about 10 g/L, preferably between about 0.5 g/L and about 3 g/L. For example, hydroquinone may be added to the bath at a concentration of about 2 g/L.

Surfactants may be added to promote wetting of the substrate. The surfactant seems to serve as a mild deposition inhibitor which can suppress three-dimensional growth to an extent, thereby improving morphology and topography of the film. It can also help to refine the grain size, which yields a more uniform bump. Exemplary anionic surfactants include alkyl phosphonates, alkyl ether phosphates, alkyl sulfates, alkyl ether sulfates, alkyl sulfonates, alkyl ether sulfonates, carboxylic acid ethers, carboxylic acid esters, alkyl aryl sulfonates, aryl alkylether sulfonates, aryl sulfonates, and sulfosuccinates.

The electrolytic plating bath of the present invention preferably has an acidic pH to inhibit anodic passivation, achieve better cathodic efficiency, and achieve a more ductile deposit. Accordingly, the bath pH is preferably between about 0 and about 3. In the preferred embodiment the pH of the bath is 0. Accordingly, the preferred acidic pH can be achieved using nitric acid, acetic acid, and methane sulfonic acid. In one preferred embodiment, the acid is methane sulfonic acid. The concentration of the acid is preferably between about 50 g/L and about 200 g/L, more preferably between about 70 g/L and about 120 g/L. For example, between about 50 g/L and about 160 g/L methane sulfonic acid can be added to the electroplating bath to achieve a bath of pH 0 and act as the conductive electrolyte.

Typical bath compositions are for example disclosed in: Jordan: The Electrodeposition of Tin and its Alloys, 1995, p. 71-84.

The plating of tin and tin alloys for solder depot plating can be performed by direct current (DC) or pulse plating. Pulse plating techniques are particularly suitable to fill structures of the present invention as shown in Figs. 2-3. The advantages of pulse plating are better surface distribution uniformity and improved crystal structures with tin deposits possessing finer grain sizes and therefore better solderability properties. Also, higher applicable current density and therefore higher throughput can be obtained by pulse plating compared to DC plating.

Generally, current pulses at an effective current density of 1 - 20 A/dm² can be applied. Alternatively, operating of the bath with DC at a current density of 1 - 3 A/dm² can be performed.

For example, applying a tin pulse plating with a current density of 3 A/dm² yields an average thickness of the tin deposit of 40 µm within 30 min. plating time. The thickness variation on the surface is only +/- 15%. Applying DC plating a maximum current density of only 1 A/dm² can be obtained. Plating time to obtain a thickness of the tin deposit of 40 µm is 86 min. The variation on the surface is +/- 33%, thus much higher than for pulse plating.

Preferred pulse parameters are as follows:
The ratio of the duration of the at least one forward current pulse to the duration of the at least one reverse current pulse is adjusted to at least 1 : 0 - 1 : 7, preferably to at least 1 : 0.5 - 1 : 4 and more preferably to at least 1:1-1: 2.5.

The duration of the at least one forward current pulse can be adjusted to preferably at least 5 ms to 1000 ms.

The duration of the at least one reverse current pulse is preferably adjusted to 0.2 - 5 ms at most and most preferably to 0.5 - 1.5 ms.

The peak current density of the at least one forward current pulse at the workpiece is preferably adjusted to a value of 1 - 30 A/dm² at most. Particularly preferable is a peak current density of the at least one forward current pulse at the workpiece of about 2-8 A/dm² in horizontal processes. In vertical processes the most preferred peak current density of the at least one forward current pulse at the workpiece is 1 - 5 A/dm² at most.

The peak current density of the at least one reverse current pulse at the work piece will preferably be adjusted to a value of 0 - 60 A/dm². Particularly preferred is a peak current density of the at least one reverse current pulse at the workpiece of about 0-20 A/dm² in horizontal processes. In vertical processes the most preferred peak current density of the at least one forward current pulse at the workpiece is 0 - 12 A/dm² at most.

In a preferred embodiment of the present invention said conductive seed layer 106 is made of copper. During reflow operations said conductive seed layer 106 is completely dissolved into the reflowed solder deposit layer 108 and forms, e.g., a homogeneous tin-copper alloy in case of a copper seed layer **106** and a tin solder deposit layer **107**. The target thickness of the conductive seed layer **106** can be adjusted depending on the volume of the solder deposit layer **107** in order to obtain e.g., a tin-copper alloy after reflow which resembles that of typical lead-free solder materials, e.g., a tin-copper alloy with 3 wt.-% copper.

The openings in the structures according to the Figs. 2-3 are denoted contact area openings **105** and preferably have a diameter of about 5 - 1.000 µm, preferably of about 10 - 500 µm and even more preferred 20 - 150 µm.

The height of the contact area openings **105** varies between 5 - 250 pm, preferably of about 10-60 µm. The distance of the center points of adjacent contacts areas is denoted as pitch and ranges from 20 - 150 µm for IC substrates, and from 150-1.000 µm for printed circuits.

Since also the temporary resin layer **104** is covered by a conductive seed layer **106** plating of the solder deposit layer **107** is also on this layer. The thickness of such a solder deposit layer **107** should preferably not exceed 0.5-10 µm and more preferred not exceed 2 - 6 µm on top of the temporary resin layer **104**.

Referring to Fig. 2f, the solder deposit layer **107** as well as the conductive seed layer **106** are being removed from the temporary resin layer **104**. Therefore, no additional etch resist is applied onto the temporary resin layer **104** prior to removal of the solder deposit layer **107** and the conductive seed layer **106** from the outer surface of the temporary resin layer **104**.

The term "etch resist" is defined herein as any kind of patterned barrier, e.g., photo imageable or screen printed organic resists and metal etch resists which prevents undesired removal of material beneath said etch resist during etching.

The removal preferably is performed by chemical etching an amount of the solder material layer containing tin or tin alloy sufficient to remove the solder deposit layer **107** and the conductive seed layer **106** from the temporary resin layer area **104** leaving a solder material layer on the at least one contact area **101** in the openings **105**. The etching of tin and tin alloys, also known as stripping, can be performed electrolytically or chemically. Also, mechanical polishing may be applied alone or in combination with electrolytical or chemical stripping to remove the solder deposit layer **107** and the conductive seed layer **106**.

Generally the tin or tin alloy solder deposit layers **107** and the conductive seed layer **106** can be removed in a single etching step with the same etching solution. In some cases it may be advantageous, however, to apply different etching solutions for removing first the solder deposit layer **107** on the temporary resin layer **104** area and thereafter the conductive seed layer **106**. Suitable etching solutions can be chosen applying routine experiments.

Typical etching or stripping compositions are for example disclosed in: Jordan: The Electrodeposition of Tin and its Alloys, 1995, p. 373-377.

During electrolytic stripping methods tin or its alloys are anodically dissolved in a 10 wt.-% NaOH solution at 70 - 90°C.

Chemical stripping generally is performed in solutions containing a strong base like NaOH (about 10 wt.-%) at elevated temperatures of 70 - 90°C. Organic additives, particularly nitroaromtaic compounds like p-nitrophenol, may be added to the solution.

Alternatively, chemical stripping can be performed in the following solutions:
- hydrogen peroxide, often with added fluoride,
- systems based on nitric acid and nitrates, 5 - 40 wt.-% of nitrate,
- systems based on HCI / copper chloride, containing 5-20 wt.-% HCl with an initial concentration of 2.5 mg/L copper chloride.

Next, the temporary resin layer **104** is removed by methods known in the art (Fig. 2 g).

At a reflow temperature, a reflowed solder deposit **108** (Fig. 2 h) can be formed from the solder deposit layer **107**.

While this process sequence has been described in detail for a substrate according to Fig. 2 it is not limited to such and may be applied to all kind of substrates. Another preferred embodiment of the present invention which can be treated accordingly is shown in Fig. 3.

As shown in Fig. 3b, a solder resin layer **109** is deposited as the permanent resin layer onto the non-conductive substrate **102**. A temporary resin layer **104** is thereafter deposited onto the non-patterned solder resin layer **109** (Fig. 3 c). Next, contact area openings **105** are formed by methods such as laser drilling, plasma etching, spark erosion or mechanical drilling (Fig. 3 d). In turn, said conductive seed layer **106** is formed (Fig. 3 e). Subsequently, the solder deposit layer **107** is formed in said opening covering the contact area **101** (Fig. 3 f). The solder deposit layer **107** as well as the conductive seed layer **106** are being removed from the temporary resin layer **104** (Figs. 3 g-h). No additional etch resist is applied onto the temporary resin layer **104** prior to removal of the solder deposit layer **107** and the conductive seed layer **106** from the outer surface of the temporary resin layer **104**.

At a reflow temperature, a reflowed solder deposit **108** (Fig. 3 i) can be formed from the solder deposit layer **107**.

In accordance with a preferred embodiment of the present invention, said electroplate solder bumps can be applied for forming flip chip joints and board to board solder joints.

The solder bumps can be any shape, such as stud bumps, ball bumps, columnar bumps, or others.

The following example further illustrates the present invention.

### Example

An IC substrate is used having a contact pad structure according to Fig. 2 a.

The non-conducting substrate **102** consists of GX-13 material (manufacturer: Ajinomoto Fine-Techno Co., Inc.), the permanent resin layer **103** consists of GX-92 material (manufacturer: Ajinomoto Fine-Techno Co., Inc., height of the layer: 25 µm) and the contact pads consist of copper.

A temporary resin layer **104** (DuPont PM 200, height: 50 µm) was laminated onto the permanent resin layer **103**.

Next, contact area openings **105** are formed through the temporary resin layer **104** and the permanent resin layer **103** with a UV laser in one step. The diameter of the contact area openings **105** is 100 µm.

The plating sequence is according to Fig. 2d to e. First, a conductive seed layer **106** of copper is formed on the entire substrate surface. For this the surface is first contacted with an acidic solution containing ionogenic palladium and then with a solution for electroless copper deposition.

Thereafter, a tin solder deposit layer **107** is plated on the conductive layer from a bath containing:
45 g/L Sn²⁺ as Sn(MSA)₂, 60 mL/L MSA (70% solution), 2 g/L Hydroquinone and 100 mg/L benzal acetone.

The pH of the bath is 0, the temperature 25 °C. Plating is for 15 min. Standard DC plating with a current density of 1 A/dm² is applied.

The contact area openings **105** according to Fig. 2d are completely filled with tin solder deposit without any void formation. Additionally, tin has been deposited on the temporary resin layer **104** area, the thickness of which is 3 µm (Fig. 2 e).

The tin solder deposit layer **107** on the temporary resin layer **104** area as well as the conductive seed layer **106** are thereafter removed by treatment in a solution containing 30 vol.-% nitric acid at a temperature of 40 °C for 1 min.

After the etching process tin solder deposit layer **107** only remains in the opening, while the tin solder deposit layer **107** as well as the conductive seed layer of copper **106** on the temporary resin layer **104** area have been entirely removed (Fig 2 f). Next, the temporary resin layer **104** is removed by immersing the substrate in an aqueous solution of 2 wt.-% potassium carbonate (Fig. 2 g). The tin solder deposit shows a very homogenous surface distribution and is whisker free. It is suited to be soldered to a chip or circuit.

## Claims

1. A method of forming a solder deposit on a substrate comprising the following steps:
i) provide a substrate **102** including at least one contact area **101** and at least one permanent resin layer **103** covering said at least one contact area **101** and at least one temporary resin layer **104** covering said permanent resin layer **103**,
ii) form at least one contact area opening **105** which extends through the temporary resin layer **104** and the permanent resin layer **103**,
iii) contact the entire substrate **102** including the permanent resin layer **103**, the temporary resin layer **104** and the at least one contact area **101** with a solution suitable to provide a conductive seed layer **106** on the substrate surface,
iv) electroplate a solder deposit layer **107** containing tin or a tin alloy onto the conductive seed layer **106**,
v) etch away an amount of the solder deposit layer **107** containing tin or tin alloy and the conductive seed layer **106** sufficient to remove both the solder deposit layer **107** and the conductive seed layer **106** from the temporary resin layer **104** area leaving a solder deposit layer **107** on the at least one contact area **101**,
wherein no etch resist is applied onto the solder deposit layer **107** between steps iv) and v).

2. A method of forming a solder deposit on a substrate according to claim 1 comprising the following steps:
i) provide a substrate **102** including at least one contact area **101** and at least one permanent resin layer **103** covering said at least one contact area **101**,
ii) deposit at least one temporary resin layer **104** covering said permanent resin layer **103**,
iii) form a least one contact area opening **105** which extends through the temporary resin layer **104** and the permanent resin layer **103**,
iv) contact the entire substrate **102** including the permanent resin layer **103**, the temporary resin layer **104** and the at least one contact area **101** with a solution suitable to provide a conductive seed layer **106** on the substrate surface,
v) electroplate a solder deposit layer **107** containing a tin or tin alloy onto the conductive seed layer **106**,
vi) etch away an amount of the solder deposit layer **107** containing tin or tin alloy and the conductive seed layer **106** sufficient to remove both the solder deposit layer **107** and the conductive seed layer **106** from the temporary resin layer **104** area leaving a solder deposit layer **107** on the at least one contact area **101**,
wherein no etch resist is applied onto the solder deposit layer **107** between steps v) and vi).

3. Method according to claim 2 wherein the permanent resin layer **103** is a solder resin layer **109**.

4. Method according to any of the foregoing claims wherein a barrier layer is plated on the at least one contact area **101**.

5. Method according to any of the foregoing claims wherein the barrier layer consists of a metal selected from the group consisting of nickel, tin, chromium, titanium, silver, gold, palladium, alloys thereof and multi layers thereof.

6. Method according to any of the foregoing claims wherein the contact area comprises a via or trench.

7. Method according to any of the foregoing claims, wherein the substrate is subjected to a reflow process to reflow the solder deposit layer **107** containing tin or a tin alloy.

8. Method according to any of the foregoing claims wherein the conductive layer is formed by electroless deposition of a metal or metal alloy selected from the group consisting of copper, copper-nickel alloys, copper-ruthenium alloys and copper-rhodium alloys.

9. Method according to any of the foregoing claims wherein the solder deposit layer **107** is a tin alloy made by the mixture of tin and the elements selected from the group consisting of lead, silver, copper, bismuth, antimony, zinc, nickel, aluminium, magnesium, indium, tellurium, and gallium.

10. Method according to any of the foregoing claims wherein the substrate is a printed circuit board, an IC substrate or an interposer.
